# EUROPEAN PATENT SPECIFICATION

(11) **EP 2 259 672 B1**
(45) Date of publication and mention of the grant of the patent: **03.07.2013**
(21) Application number: 09714913.2
(22) Date of filing: 23.02.2009
(51) Int. Cl.: H05K 13/04

(54) **VACUUM SUCTION NOZZLE**
UNTERDRUCKSAUGDÜSE
BUSE D'ASPIRATION SOUS VIDE

(30) Priority: 26.02.2008 JP 2008043874
(43) Date of publication of application: 08.12.2010
(73) Proprietor: Kyocera Corporation, Kyoto-shi Kyoto 612-8501 (JP)
(72) Inventor: HAMASHIMA, Hiroshi, Satsumasendai-shi Kagoshima 895-0292 (JP)
(74) Representative: HOFFMANN EITLE
(86) International application number: PCT/JP2009/053187
(87) International publication number: WO 2009/107581

(56) References cited:
- WO-A1-2005/061188
- WO-A1-2007/099725
- JP-A- 8 274 126
- JP-A- 9 094 788
- JP-A- 2005 168 622

## Description

### Technical Field

The present invention relates to a vacuum suction nozzle suitably used in an electronic component mounter for mounting chip electronic components such as chip capacitor or chip resistor on a circuit board.

### Background Art

Chip electronic components such as chip capacitor or chip resistor have conventionally been mounted by picking up the component by vacuum suction onto a suction surface provided at a tip end portion of a vacuum suction nozzle installed on an electronic component mounter, carrying the component in this state and placing it at a predetermined position of a circuit board. A position of the chip electronic component is determined by directing light to the chip electronic component, capturing a reflected light therefrom with a CCD camera, and analyzing a shape of the chip electronic component or the positions of electrodes with an image analyzing apparatus.

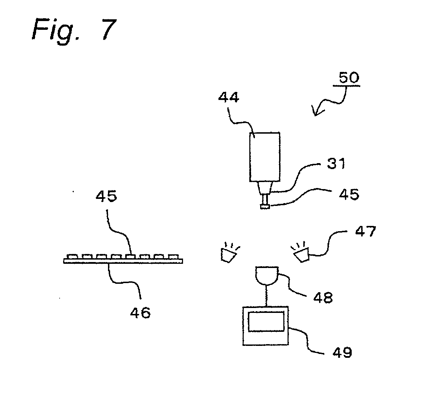

Fig. 7 schematically shows a constitution of an electronic component mounting apparatus that uses the electronic component mounter equipped with the vacuum suction nozzle for mounting chip electronic components on the circuit board.

The electronic component mounting apparatus 50 shown in Fig. 7 includes a vacuum suction nozzle 31 installed on an electronic component mounter 44, a tray 46 having electronic components 45 placed thereon, a light 47 for directing light to the electronic components 45 suctioned by the vacuum suction nozzle 31, a CCD camera 48 that receives reflected light from the electronic components 45, and an image analyzing apparatus 49 that applies image analysis to the reflected light received by the CCD camera 48.

In the electronic component mounting apparatus 50, when the vacuum suction nozzle 31 moves to the tray 46 and picks up the electronic component 45 placed on the tray 46, the light 47 directs light to the electronic component 45 suctioned by the vacuum suction nozzle 31, and the CCD camera 48 receives the light reflected on the body and the electrodes of the electronic component 45. Image captured by the CCD camera 48 is analyzed by an image analyzing apparatus 49 to determine a position of the electronic component 45. Based on this data, the vacuum suction nozzle 31 carrying the electronic component 45 suctioned thereon is moved to a predetermined position of a circuit board (not shown) thereby to mount the electronic component 45 on the circuit board.

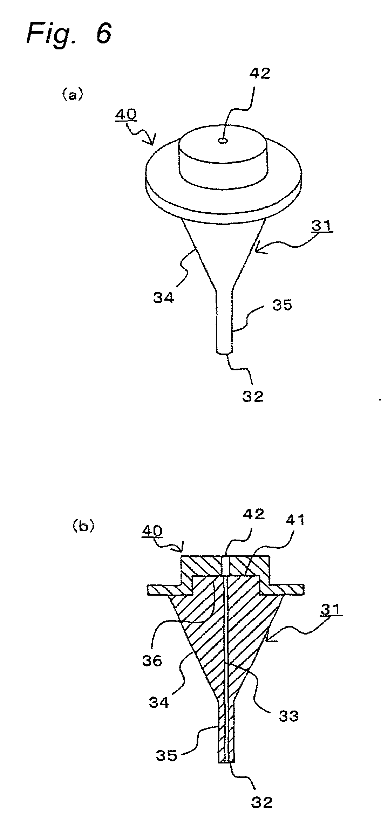

Fig. 6 shows an example of a constitution of the vacuum suction nozzle as incorporated into a holding member of the electronic component mounter, Fig. 6(a) is a perspective view thereof and Fig. 6(b) is a longitudinal sectional view thereof.

The vacuum suction nozzle 31 has a cylindrical portion 35 having a suction surface 32 formed on the tip end face for holding an electronic component by vacuum suction, a conical portion 34 that tapers off toward the cylindrical portion 35 and is provided on the side of the cylindrical portion 35 opposite to the suction surface 32, and a head 36 provided on the end face of the base where the conical portion 34 opposes the suction surface 32. A hole penetrating the cylindrical portion 35 through the center thereof extends into the conical portion 34 and the head 36 to form a suction orifice 33.

The holding member 40 has a socket 41 formed at the center thereof, into which the head 36 of the vacuum suction nozzle 31 fits, with a suction orifice 42 formed at the center thereof being communicating with the suction orifice 33, so that the head 36 of the vacuum suction nozzle 31 is fitted into the socket 41 and mounted on the electronic component mounter. The vacuum suction nozzle 31 is formed from a material such as ceramics or cemented carbide having a high wear resistance.

Patent Document 1, for example, describes that a position of a chip component can be detected by using ceramics having a high wear resistance in the tip end portion of the suction nozzle that suctions the chip component and rendering the tip end portion of the suction nozzle with a color that has a lower image input level than that of the chip component when the tip end portion of the suction nozzle is captured by the camera. It is also described that the suction nozzle has a high wear resistance and an image processing can be carried out reliably when the chip component is picked up by the nozzle.

Patent Document 2 discloses a filter for blocking foreign matters from entering a vacuum suction circuit, for a purpose of preventing the suction orifice from being clogged by foreign matters such as tiny grit and dust contained in the atmosphere since the foreign matters are taken therein, together with the surrounding air when a vacuum suction operation by the suction nozzle is carried out. Namely, such a suction head used for a vacuum suction of the electronic components is disclosed in which a suction nozzle comprises a nozzle mounting section whereon the suction nozzle is detachably mounted, a suction orifice communicating between the suction nozzle mounted on the nozzle mounting section and a vacuum source, and a filter being installed in the suction orifice and capturing foreign matters being taken therein through the suction nozzle, wherein the filter comprises a thin meshed film made by weaving thin metal wires, a fastening means for fastening the meshed film onto a holder, and a filter mounting means detachably mounting the holder in the suction orifice.

Conventional filter uses a porous material that allows a gas to flow through a multitude of fine continuous holes and causes significant pressure loss during a vacuum suction operation, thus making it necessary to provide a vacuum source of a high vacuum capability. In contrast, it is described that this suction head decreases the pressure loss caused by the filter, since the filter is constituted from a thin meshed film made by weaving thin metal wires, a fastening means for fastening the meshed film onto a holder, and a filter mounting means detachably mounting the holder onto the suction orifice.

Patent Document 3 discloses an electronic component mounting apparatus that holds an electronic component by means of a mounting tool and mounts the electronic component on a circuit board coated with a resin adhesive, the electronic component mounting apparatus comprising: the mounting tool having a suction nozzle that holds the electronic component by vacuum suctioning provided on the bottom end thereof; a resin adhesion preventing member that has a resin blocking section having a shape of surrounding the periphery of the lower part of the suction nozzle and is disposed movably in the vertical direction relative to the suction nozzle; and a vertical drive means that drives the resin adhesion preventing member to move vertically, wherein the resin blocking section of the resin adhesion preventing member touches the top surface of the electronic component held by the suction nozzle by vacuum suction, thereby preventing the resin adhesive, that has been squeezed to move onto the top surface of the electronic component during the mounting operation, from depositing onto the lower end of the suction nozzle. In case that a resin adhesive such as an epoxy resin is used in the process of mounting electronic components such as flip chip component on a circuit board, the resin adhesive may be squeezed to move from a side face to a top surface of the electronic component after the electronic component has been placed on the resin adhesive, when an excessive amount of the resin adhesive has been applied thereon. However, it is described that according to this electronic component mounting apparatus, such a mounting failure can be prevented from occurring, the mounting failure being such that the resin adhesive having been squeezed to move to the top surface of the electronic component adheres to a lower end of the suction nozzle and causes the electronic component to be lifted together with the suction nozzle when it is attempted to release the electronic component by lifting the suction nozzle.

Patent Document 4 discloses a suction nozzle cleaning method comprising a high-temperature gas blowing step wherein a high-temperature gas is blown into an orifice of a suction nozzle, and an air blowing step wherein air is blown at a predetermined pressure into the orifice of the suction nozzle after the high-temperature gas blowing step. It is described that this method makes it possible to surely and cleanly wash an inside of the suction nozzle in a short period of time even if foreign matters would be firmly stuck thereon. In addition, according to the above method, an operating rate does not decrease, since the nozzle can be cleaned even when the nozzle is mounted on the electronic component mounting apparatus.

Furthermore, Patent Document 5 discloses a suction nozzle cleaning apparatus for removing foreign matters deposited onto a tip end portion of a suction nozzle for carrying an object held thereon by vacuum suctioning, the suction nozzle cleaning apparatus comprising: a cleaning pad having an elastic material stuck thereon; a vertical motion mechanism for pressing and releasing the tip end portion of the suction nozzle against and from the elastic material; and an ultrasonic generator for applying an ultrasonic vibration to the suction nozzle and/or the cleaning pad. It is described that according to this apparatus, foreign matters can be captured in the elastic material by applying an ultrasonic vibration to a surface of the elastic material with the tip end portion of the suction nozzle caused to sink into the elastic material in order to break the surface of the elastic material, and therefore the cleaning operation conducted more surely and uniformly by using a synthetic resin film of relatively low cost with less amount of consumption can be achieved.
Patent Document 1: Japanese Unexamined Patent Publication (Kokai) No. 2-90700
Patent Document 2 Japanese Unexamined Patent Publication (Kokai) No. 2002-301677
Patent Document 3: Japanese Unexamined Patent Publication (Kokai) No. 2003-249793
Patent Document 4: Japanese Unexamined Patent Publication (Kokai) No. 2007-98241
Patent Document 5: Japanese Unexamined Patent Publication (Kokai) No. 2004-146477

### Disclosure of the Invention

### Problems to be Solved by the Invention

Recently in such a process as a vacuum suction nozzle is caused to move at a high speed to pick up an electronic component from a tray and carry the electronic component to a circuit board so as to mount it on the circuit board, the circuit board and the electronic component to be mounted thereon are becoming increasingly smaller in size, and the number of electronic components to be mounted has been increasing. Therefore it is required to improve the efficiency of the vacuum suction nozzle to pick up an electronic component and mount it on the circuit board. Particularly in the trend toward smaller vacuum suction nozzle as the electronic components become smaller in size, the suction orifice of the vacuum suction nozzle has been decreasing in diameter. As a result, such a problem has become serious that the suction orifice is clogged as foreign matters such as tiny grit and dust contained in the atmosphere is suctioned along with the surrounding air. Also since the solder is switched to lead-free solder in view of an environmental response, the electrodes formed on the electronic components are softened, thus resulting in more electrode material being prone to depositing on the vacuum suction nozzle.

There is no suggestion in Patent Document 1 of a solution to the problems described above. Also Patent Document 2 merely describes the filter installed in the vacuum suction circuit that is separated from the vacuum suction nozzle, and does not suggest any attempt to remove foreign matters deposited on the inner surface of the suction orifice of the vacuum suction nozzle.

Patent Document 3 discloses preventive measures against a resin adhesive being depositing on a lower end of the suction nozzle due to the fact that the resin adhesive being moving onto a top surface of the electronic component. However, it does not suggest preventive measures against foreign matters being depositing on the inner surface of the suction orifice.

Patent Document 4 discloses a method of washing foreign matters firmly deposited in the suction orifice of the vacuum suction nozzle. However, it does not provide a basic solution for making it difficult for the foreign matters to deposit on the inner surface of the suction orifice.

Patent Document 5 discloses a suction nozzle cleaning method for removing foreign matters deposited onto the tip end portion of the suction nozzle for carrying an object held thereon by vacuum suctioning. However, it does not provide a basic solution for making it difficult for the foreign matters to deposit on the inner surface of the suction orifice like Patent Document 4.

An object of the present invention is to provide a vacuum suction nozzle that is less likely to have foreign matters deposited on the inner surface of the suction orifice of the vacuum suction nozzle, requires less cleaning and has high operating rate.

### Means for Solving the Problems

The present inventors have intensively studied in light of the problems described above, and found that, when an electronic component is picked up by the vacuum suction nozzle, grit and dust that has been taken in and solder fragments of electrodes formed on the surface of the electronic component are charged with the static electricity, and the suction orifice of the vacuum suction nozzle is blocked by the charged grit, dust and solder fragments. Furthermore, the present inventors have intensively studied and found that the vacuum suction nozzle can be effectively suppressed from being blocked by the charged grit and dust and charged solder fragments, by forming protrusions having an electrical resistance lower than that of a main component of the ceramics constituting the vacuum suction nozzle, on the inner surface of the suction orifice, which cause the static electricity of grit, dust and solder fragments to be discharged through the vacuum suction nozzle to the electronic component mounting apparatus upon contact with the protrusions of lower electrical resistance, thus leading to the present invention.
Accordingly, the vacuum suction nozzle of the present invention comprises: a base comprising a suction surface on the tip end portion thereof; and a suction orifice configured to penetrate through the base and communicate to the suction surface, wherein the tip end portion of the base, including at least the suction surface, is formed from ceramics, and a plurality of protrusions which have an electrical resistance lower than that of a main component of the ceramics and are formed on an inner surface of the suction orifice.

### Effects of the Invention

A vacuum suction nozzle of the present invention comprises a suction surface formed from ceramics for holding an object by vacuum suction, and a suction orifice formed in such a manner to communicate with the suction surface, wherein a plurality of protrusions having an electrical resistance lower than that of the main component of the ceramics are formed on the inner surface of the suction orifice. Therefore, although grit and dust contained in the atmosphere and solder fragments of electrodes formed on the surface of the electronic component are taken into the suction orifice together with air when the electronic component is suctioned by the vacuum suction, and are often charged with the static electricity, the static electricity is discharged toward the protrusions upon contact with the protrusions formed on the inner surface of the suction orifice. Accordingly, it is possible to suppress a deposition of grit and dust contained in the atmosphere and solder fragments of electrodes formed on the surface of the electronic component, on the inner surface of the suction orifice, due to an electrostatic force.
Thus, according to the present invention, it is possible to provide a vacuum suction nozzle that is less likely of depositing the deposits on the inner surface of the suction orifice of the vacuum suction nozzle, requires less cleaning, and has high operating rate.

### Brief Description of the Drawings

Fig. 1(a) is a perspective view showing an example of the embodiment of a vacuum suction nozzle of the present invention mounted in a holding member, and Fig. 1(b) is a schematic view of the example shown in Fig. 1(a).
Fig. 2 is a schematic view showing a constitution of an electronic component mounting apparatus using the vacuum suction nozzle of the present invention.
Fig. 3 shows an example of the constitution of the protrusions formed on the inner surface of the suction orifice as viewed from the suction surface side of the vacuum suction nozzle of the present invention, Fig. 3(a) is a perspective view and Fig. 3(b) is a sectional view taken along lines A-A' in Fig. 3(a).
Fig. 4 is a front view showing a method for measuring the electrical resistance between a front end and a rear end of the vacuum suction nozzle 1.
Fig. 5 is a schematic view showing a shape of the protrusions 7 formed on the inner surface of the suction orifice 3 of the vacuum suction nozzle 1, Fig. 5(X) shows a semi-spherical shape, Fig. 5(Y) shows a crater-like shape and Fig. 5(Z) shows a chevron shape.
Fig. 6 shows an example of a constitution of a vacuum suction nozzle of the prior art, as assembled in a holding member of an electronic component mounting machine, Fig. 6(a) showing a perspective view and Fig. 6(b) showing a longitudinal sectional view.
Fig. 7 is a schematic view showing a constitution of an electronic component mounting apparatus that mounts chip electronic components on a circuit board by using the electronic component mounting machine having the vacuum suction nozzle of the prior art.

### Description of Reference Numerals

1: Vacuum suction nozzle
2: Suction surface
3: Suction orifice
4: Conical portion
5: Cylindrical portion
6: Head
7: Protrusion
10: Holding member

### Best Mode for Carrying Out the Invention

The vacuum suction nozzle according to the embodiment of the present invention will be described below with reference to the accompanying drawings.

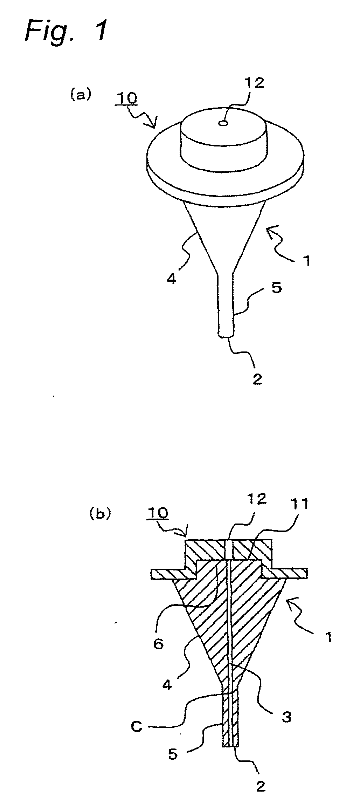

Fig. 1 shows an example of a constitution of a vacuum suction nozzle according to the present invention, as assembled in a holding member of an electronic component mounting machine, Fig. 1(a) showing a perspective view and Fig. 1(b) showing a longitudinal sectional view.

The vacuum suction nozzle 1 as the example shown in Fig. 1 comprises a cylindrical portion 5 having a suction surface 2 formed on the tip end face thereof for holding an electronic component (not shown) by vacuum suction, a conical portion 4 that tapers off toward the cylindrical portion 5 and is provided on the one side of the cylindrical portion 5 opposite to the suction surface 2 of the cylindrical portion 5, and a head 6 provided on an end face at a root of the conical portion 4, the end face being opposing the suction surface 2. The inner hole penetrating the cylindrical portion 5 and opening in the suction surface 2 extends through the conical portion 4 and the head 6 and opens in the surface of the head 6, thus constituting the suction orifice 3. The "base" of the present invention refers to the conical portion 4 and the cylindrical portion 5 combined, and the phrase "the tip end portion of the base including the suction surface 2" refers to a certain area of the base consisting of the conical portion 4 and the cylindrical portion 5 including the suction surface 2. In the vacuum suction nozzle of the present invention, it suffices that at least a portion near the suction surface 2 is formed from ceramics, but it goes without saying that whole of the conical portion 4 and the cylindrical portion 5, namely the entire base may also be formed from ceramics.

The holding member 10 holds the vacuum suction nozzle 1 by fitting the head 6 of the vacuum suction nozzle 1 in a recess 11, so that the vacuum suction nozzle 1 can be installed on the electronic component mounting machine (not shown) via the holding member 10. The holding member 10 has the socket 11 wherein the head 6 of the vacuum suction nozzle 1 is fitted and the suction orifice 12 formed to communicate with the suction orifice 3 of the vacuum suction nozzle 1.

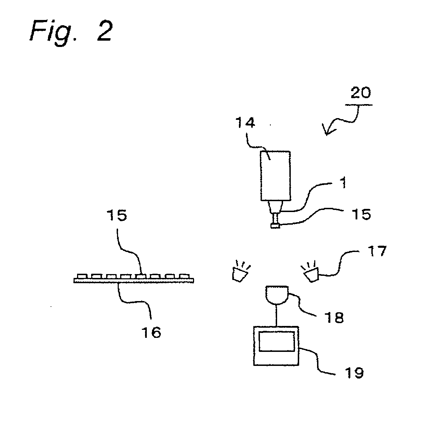

Fig. 2 schematically shows the constitution of an electronic component mounting apparatus that mounts chip electronic components on a circuit board by using the electronic component mounting machine having the vacuum suction nozzle 1 of the present invention.

The electronic component mounting apparatus 20 shown in Fig. 2 comprises the vacuum suction nozzle 1 installed on the electronic component mounting machine 14, a tray 16 carrying the electronic components 15 arranged thereon, a light 17 that directs light to the electronic component 15 suctioned by the vacuum suction nozzle 1, a CCD camera 18 that captures a reflected light of the light 17, and an image analyzing apparatus 19 that applies image analysis to the reflected light (image) captured by the CCD camera 18.

In the electronic component mounting apparatus 20, the vacuum suction nozzle 1 moves to the tray 16 and picks up the electronic component 15 apposed on the tray 16. The light 17 directs light to the electronic component 15 suctioned by the vacuum suction nozzle 1, and the CCD camera 18 receives the light reflected on the electronic component 15 and the electrodes thereof. The image captured by the CCD camera 18 is analyzed by the image analyzing apparatus 19 to determine a position of the electronic component 15, then the vacuum suction nozzle 1 carrying the electronic component 15 is moved to a predetermined position of the circuit board (not shown) in accordance with this data thereby to mount the electronic component 15 on the circuit board.

In the vacuum suction nozzle 1 of the present invention, it is important that it comprises the cylindrical portion (base) 5 having the suction surface 2 formed on the tip end face thereof for holding an object by vacuum suction, and the suction orifice 3 penetrating through the cylindrical portion (base) 5 and communicating to the suction surface 2, wherein the tip end portion including at least the suction surface 2 is formed from ceramics, and a plurality of protrusions, that have an electrical resistance lower than that of the main component of the ceramics, are formed on the inner surface of the suction orifice 3.

The term "main component" as used herein refers to a component that accounts for not less than 50% by mass relative to 100% by mass of the entire components that constitute the ceramics. It is preferable that a kind of ceramics having high wear resistance and high mechanical strength as required for the vacuum suction nozzle 1 is used as the main component.

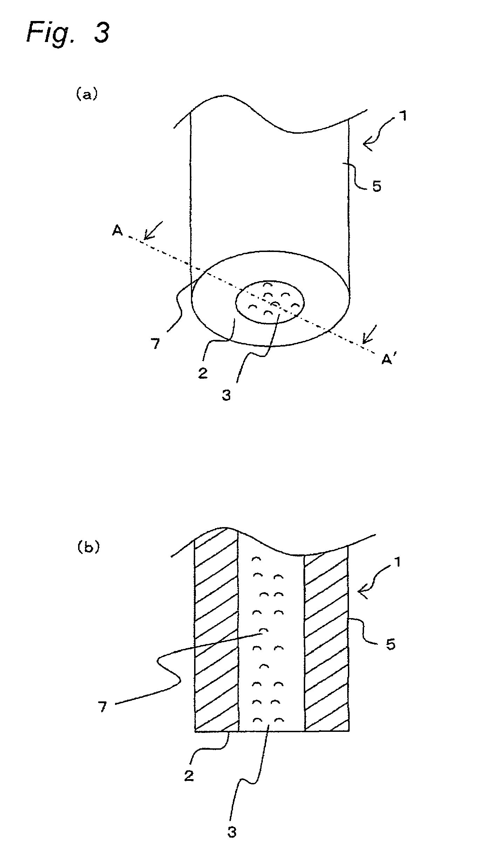

Fig. 3 shows an example of a constitution of the protrusions formed on the inner surface of the suction orifice as viewed from the suction surface side of the vacuum suction nozzle of the present invention, Fig. 3(a) showing a perspective view and Fig. 3(b) showing a sectional view taken along lines A-A' in Fig. 3(a).

As shown in Fig. 3(a) and Fig. 3(b), the vacuum suction nozzle 1 has a plurality of protrusions 7, that have an electrical resistance lower than that of the main component of the ceramics of the suction surface 2, the plurality of protrusions 7 being formed on the inner surface of the suction orifice 3.

When an electronic component (not shown) is suctioned, grit and dust contained in the atmosphere and solder fragments of electrodes formed on the surface of the electronic component are taken into the suction orifice 3 together with air and are often charged with the static electricity. However, as the plurality of protrusions 7 that have an electrical resistance lower than that of the main component of the ceramics of the suction surface 2 are formed on the inner surface of the suction orifice 3 as described above, the static electricity is discharged via the vacuum suction nozzle 1 to the electronic component mounting apparatus 20 upon contact with the protrusions 7. As a result, grit and dust contained in the atmosphere and solder fragments are suppressed from depositing on the inner surface of the suction orifice 3 by the electrostatic force.

The protrusions 7 can be formed by making the vacuum suction nozzle 1 from ceramics that contains a conductivity imparting agent. In case that the suction surface 2 is formed from ceramics and the other component is formed from a metal, the protrusions 7 can be formed by a surface texturing of the inner surface of the suction orifice 3 by means of an electric discharge machine. In this case, the same effect can be achieved even when the ceramics are formed of an insulating material as long as an electric continuity is maintained in the inner surface of the suction orifice 3.

The protrusions 7 may be formed from ceramics containing a conductivity imparting agent, a metal or other electrically conductive material such as cemented carbide.

It is preferable that the protrusions 7 formed on the inner surface of the suction orifice 3 in the vacuum suction nozzle 1 of the present invention have a semi-spherical shape. In case that the protrusions 7 have a semi-spherical shape, grit and dust contained in the atmosphere and solder fragments that are taken into the suction orifice 3 in the picking up of an object by vacuum suction, tend to roll over along with an air stream even if the grit, dust and solder fragments collided with the protrusions 7 formed on the inner surface of the suction orifice 3. As a result, foreign matters such as the grit, dust and solder fragments are suppressed from being caught by the protrusions 7 and foreign matters can be suppressed from depositing sequentially on the inner surface of the suction orifice 3 due to trapping of foreign matters.

In the vacuum suction nozzle 1 of the present invention, it is preferable that a height of the protrusions 7 is not more than 30 µm.

General sizes of grits and dusts contained in the atmosphere and solder fragments of electrodes formed on the surface of the electronic component 15 are in a range from several micrometers to several tens of micrometers. In case that the height of the protrusions 7 is not more than 30 µm, such foreign matters can easily roll over when taken into the suction orifice 3 and colliding with the protrusions 7. As a result, a movement of foreign substances such as grit and dust and solder fragments is not completely stopped, thus preventing the foreign matters from depositing on the inner surface of the suction orifice thereby stopping the air flow in the suction orifice 3. Thus it is made possible to continue the suctioning operation stably over a long period of time, while experiencing almost no dropping or positional deviation of the object. The height of the protrusions 7 is preferably not less than 1 µm which is the average size of grit and dust in the room.

In the vacuum suction nozzle 1 of the present invention, it is preferable that the height of the protrusions 7 is not more than 10% of a diameter of the suction orifice 3.

As described above, the height of the protrusions 7 is preferably not more than 30 µm. In case that the suction orifice 3 has a small diameter, for example, the suction orifice 3 may be blocked when a plurality of foreign matters particles measuring several micrometers to several tens of micrometers, the sizes of grit and dust contained in air and solder fragments of electrodes formed on the surface of the electronic component 15, are sucked at the same time and deposited on a part of the suction orifice 3. Foreign matters may further deposit at the blocked position to make it difficult to take in air, which may result in dropping or positional deviation of the object. For this reason, it is preferable that the height of the protrusions 7 is not more than 10% of the diameter of the suction orifice 3. When the height of the protrusions 7 is more than 10% of the diameter of the suction orifice 3, there is a higher possibility of the suction orifice 3 to be blocked by a plurality of foreign matters particles. Specifically, in case that the height of the protrusions 7 is not more than 10% of the diameter of the suction orifice 3, there is less resistance to the air flowing through the suction orifice 3 when the air is taken into the suction orifice 3 for vacuum suction of the object, so that sufficient suction force is stably obtained without drop in the suction force. The height of the protrusion 7 can be determined by observing an inside of the suction orifice 3 under a tool microscope with magnification of not less than 100 times with the vacuum suction nozzle 1 placed so that the suction surface 2 faces upward, and measuring the height difference between the highest point of the protrusion 7 and the bottom of the inner surface of the suction orifice 3.

In the vacuum suction nozzle 1 of the present invention, it is preferable that a surface roughness (an arithmetic mean roughness Ra) of the inner surface of the suction orifice 3 is not more than 0.5 µm. When the inner surface of the suction orifice 3 is made smooth with the surface roughness (arithmetic mean roughness Ra) of not more than 0.5 µm, there is a lower possibility of grit, dust or solder fragments, even when taken in during vacuum suction of the electronic component 15, to be caught on the inner surface of the suction orifice 3. Thus foreign matters can be suppressed from depositing on the inner surface of the suction orifice more effectively.

In the vacuum suction nozzle 1 of the present invention, it is preferable that the surface roughness (a maximum height Rmax) of the inner surface of the suction orifice 3 is not less than 0.6 µm nor more than 5.5 µm. When the surface roughness (maximum height Rmax) of the inner surface of the suction orifice 3 is in a range from 0.6 to 5.5 µm, since the protrusions 7 are formed from the conductivity imparting agent, grit, dust or solder fragments will not be caught by the protrusions 7 and deposit thereon even when the grit, dust or solder fragments are taken in during vacuum suction of the electronic component 15. Also because the static electricity is discharged through the protrusions 7 to the electronic component mounting apparatus 20, grit, dust and solder fragments are suppressed from depositing on the inner surface of the suction orifice 3 by the electrostatic force. When the surface roughness (maximum height Rmax) is less than 0.6 µm, in particular, grit, dust and solder fragments become less likely to touch the protrusions 7 during vacuum suction of the electronic component 15, thus making it impossible to discharge the foreign matters of the static electricity. When the surface roughness (maximum height Rmax) is more than 5.5 µm, on the other hand, grit, dust and solder fragments tend to be caught by the protrusions 7 during vacuum suction of the electronic component 15, leading to clogging of the suction orifice 3. The surface roughness (maximum height Rmax) is more preferably in a range from 0.66 to 4.8 µm, which enables it to suppress the grit, dust and solder fragments from depositing due to the electrostatic charge. It also suppresses the flow rate from decreasing and effectively decreases suction failure of the electronic component 15, because a part of air stream flowing through the suction orifice 3 forms eddy currents upon collision with the protrusions 7, and the eddy currents decrease the frictional resistance of the inner surface of the suction orifice 3 to the main stream of air flow.
The surface roughness (arithmetic mean roughness Ra and maximum height Rmax) can be measured by the following procedure. First, the vacuum suction nozzle 1 is cut off along the axial direction by a laser cutter or the like, and the inner surface of the suction orifice 3 that has been cut is measured along the axial direction of the vacuum suction nozzle 1 by using a commonly used surface roughness measuring instrument. The measurement is conducted under the conditions defined in JIS B0601 (2001), with measuring length of 4.8 mm, cutoff value of 0.8 mm and probe diameter of 5 µm.

In the vacuum suction nozzle 1 of the present invention, the protrusions 7 preferably contain at least one selected from the group consisting of iron oxide, titanium oxide, chromium oxide and cobalt oxide.

When the protrusions 7 contains at least one kind of iron oxide, titanium oxide, chromium oxide and cobalt oxide, an electrical conductivity can be imparted to the protrusions 7 formed of ceramics containing these oxides, or these oxides. These iron oxide, titanium oxide, chromium oxide and cobalt oxide are suitable because they have smaller electrical resistance than that of ceramics of the main components used in the vacuum suction nozzle 1. These iron oxide, titanium oxide, chromium oxide and cobalt oxide are particularly preferable when compared with other conductivity imparting agents because they are likely to be precipitated in the case of sintering in air atmosphere. These oxides can be stably precipitated without being precipitated into an abnormal shape. Therefore, it is possible to easily form the protrusions 7 into a semi-spherical shape by a surface tension of iron oxide, titanium oxide, chromium oxide and cobalt oxide that begin to be precipitated from grain boundaries of ceramics as the main components in the case of cooling after sintering.

Iron oxide, titanium oxide, chromium oxide and cobalt oxide are likely to be precipitated as the protrusions 7 on a surface layer by sintering in air atmosphere even in a conductivity imparting agent having particularly small electrical resistance, and also can stably exist in the ceramic sintered body. It is also possible to suitably obtain semi-conductive property even by mixing with zirconia and alumina that are commonly used as the main components of ceramics.

When the protrusions 7 are formed from an oxide such as iron oxide, titanium oxide, chromium oxide or cobalt oxide, the static electricity can be easily discharged by the protrusions 7 even when the protrusions 7 are electrostatically charged, because the protrusions 7 have low electrical resistance. Moreover, since these oxides are chemically stable and undergo less temporal change in electrical resistance, the ease of discharging the static electricity can be maintained stably over a long period of time. Also because the protrusions can be formed in a semi-spherical shape by controlling the sintering temperature, grit and dust contained in the atmosphere and solder fragments of electrodes formed on the surface of the electronic component can be suppressed from depositing on the inner surface of the suction orifice 3 stably over a long period of time.

The vacuum suction nozzle 1 of the present invention may have insulating or semi-conductive property. When the vacuum suction nozzle 1 has semi-conductive property, electrical resistance between the front end and the rear end of the vacuum suction nozzle 1 may be set in a range from 10³ Ω to 10¹¹ Ω, which makes it possible to suppress the vacuum suction nozzle 1 from being charged with the static electricity generated through friction with air when the vacuum suction nozzle 1 moves at a high speed. This enables to suppress an occurrence of such troubles that the electronic component 15 is moved or blown off by the repulsive force of the static electricity or that the electronic component 15 remains suctioned onto the vacuum suction nozzle 1 and cannot be mounted on a circuit board, and thus is carried back.

When the electrical resistance between the front end and the rear end of the vacuum suction nozzle 1 is in a range from 10³ Ω to 10¹¹ Ω, even if the vacuum suction nozzle 1 is charged with the static electricity, the static electricity can be discharged through the holding member 10 and the electronic component mounting machine 20. As a result, it is made possible to suppress the static electricity from being suddenly discharged from the vacuum suction nozzle 1 to the surrounding components and causing an electrostatic breakdown of the surrounding components. Also because the static electricity is discharged from the vacuum suction nozzle 1, it is made possible to prevent the electronic component 15 from being blown off by the repulsive force of the static electricity, or prevent the electronic component 15 from being attracted to the suction surface 2 by the static electricity and becoming unable to release from the suction surface 2, resulting in a failure of mounting on the circuit board and carry-back. When the electrical resistance is lower than 10³ Ω, the components surrounding the vacuum suction nozzle 1, if they are charged with the static electricity, tend to discharge and cause the electrostatic breakdown of the electronic component 15 that is suctioned thereon. In contrast, when the electrical resistance is higher than 10¹¹ Q, the vacuum suction nozzle 1 tends to be charged with the static electricity. As a result, when the vacuum suction nozzle 1 approaches the electronic component 15, the electronic component 15 may be blown off by the repulsive force of the static electricity or the electronic component 15 may be attracted to the suction surface 2 by the static electricity charged on the vacuum suction nozzle 1 and become unable to release from the suction surface 2, thus making it impossible to mount the electronic component 15 on the circuit board and causing it to be carried back.

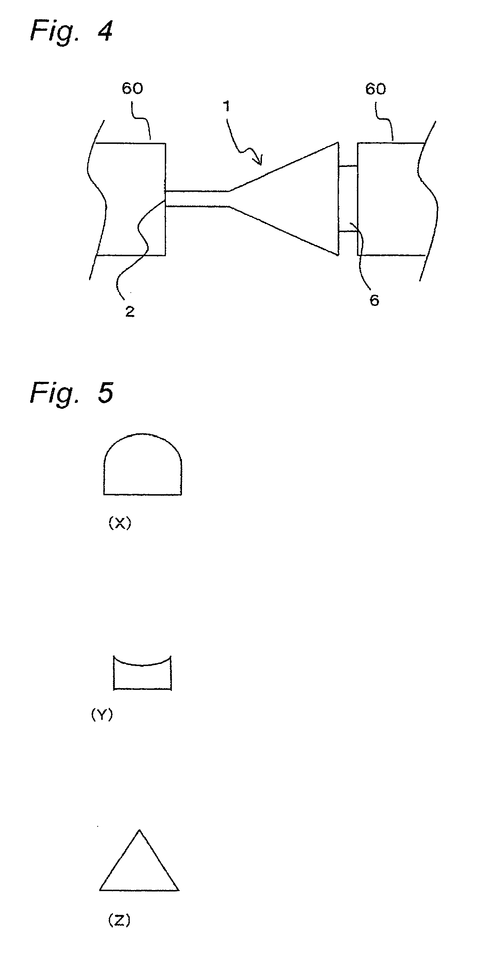

Fig. 4 is a front view showing a method for measuring the electrical resistance between the front end and the rear end of the vacuum suction nozzle 1, depicting an electrode 60 put into contact with the suction surface 2 at the tip end portion of the vacuum suction nozzle 1, and the other electrode 60 put into contact with the end face of the head 6 at the rear end. The electrodes 60, 60 are connected to a resistance meter (not shown). The electrical resistance between the front end and the rear end of the vacuum suction nozzle 1 can be measured by applying a voltage across the electrodes 60, 60 on the tip end portion and the rear end of the vacuum suction nozzle 1. The voltage applied for the measurement may be set in accordance with the shape and material of the vacuum suction nozzle 1, while about 10 to 1,000 V may be employed.

The suction surface 2 is preferably not more than 0.7 mm in diameter. This is for the purpose of suppressing such a problem from occurring, the problem being such that the suction surface 2 or the cylindrical portion 5 is chipped off by colliding with the electronic component that has been previously mounted and another components that are mounted around it, when the electronic component 15 having a rectangular shape measuring not more than 1 mm along the longitudinal side is picked up and mounted on the circuit board that has components mounted thereon in a high density. When the suction surface 2 is larger than 0.7 mm in diameter, a possibility of the suction surface 2 or the cylindrical portion 5 colliding with and breaking the electronic component that has been previously mounted and the surrounding components becomes higher when the electronic component 15 having a rectangular shape measuring not more than 1 mm along the longitudinal side is picked up and mounted on the circuit board having components mounted thereon in a high density. For example, when the electronic component 15 is a chip component of type 0603 (measuring 0.6 mm by 0.3 mm), distance between adjacent components mounted on the circuit board may be about 0.1 mm. Therefore, even if a slight positional deviation of the electronic component 15 in the suctioning of the electronic component 15 onto the suction surface 2 may occur, it causes the suction surface 2 or the cylindrical portion 5 to collide with and break the components disposed around the mounting position when the electronic component 15 is mounted.

Moreover, a use of ceramics in the vacuum suction nozzle 1 enables it to suppress a wearing of the suction surface 2 due to repetitive operations of picking up and releasing the electronic component 15. The ceramic material to be used may be, for example, known zirconia, or zirconia containing alumina.

It is also preferable that the ceramics used in the vacuum suction nozzle 1 of the present invention contains a conductivity imparting agent.

The vacuum suction nozzle 1 having a desired level of electrical resistance can be made by ceramics containing a conductivity imparting agent as ceramics used in the vacuum suction nozzle 1.

While an alumina is an insulating ceramics, it is low-cost and has high wear resistance. Thus, a vacuum suction nozzle 1 having an excellent wear resistance and a moderate level of electrical conductivity can be made by adding conductivity imparting agent such as titanium carbide or titanium nitride to alumina and using this material. Similarly, zirconia is a material having high strength, and acquires a moderate level of electrical conductivity by adding the conductivity imparting agent such as iron oxide, titanium oxide or zinc oxide. Using this material makes it possible to make the vacuum suction nozzle 1 that is less likely to break even when formed in a thin shape. Use of silicon carbide ceramics enables it to make the vacuum suction nozzle 1 having a controlled value of electrical resistance by adding carbon as the conductivity imparting agent.

Ceramics used for the vacuum suction nozzle 1 of the present invention are preferably formed from black ceramics.

When the electronic component 15 suctioned by the vacuum suction nozzle 1 is illuminated by the light 17 and is captured by the CCD camera 18, the electronic component 15 is clearly imaged by a reflected light of the light 17. When the vacuum suction nozzle 1 is formed from black ceramics as described above, the electronic component 15 can be imaged with clear profile, as the image of the electronic component 15 is captured against the dark background of the vacuum suction nozzle 1. As a result, the image analyzing apparatus 19 can correctly recognize the position of the electronic component 15 suctioned by the vacuum suction nozzle 1, so that positional accuracy is improved when mounting the electronic component 15 on the circuit board.

Examples of the black ceramics include zirconia, alumina and silicon carbide each containing a blackish conductivity imparting agent added therein. Also, even when ceramics having other color tones such as brownish or bluish color tone are used, they can exert the same effect as that of black ceramics by imparting a dark color tone.

Examples of the blackish conductivity imparting agent that can be added to for example, alumina ceramics or the conductivity imparting agent that can be used for providing the dark color tone therewith even if the ceramics have the brownish or bluish color tone, include iron oxide, manganese oxide, cobalt oxide, nickel oxide, titanium carbide and titanium nitride. Of these conductivity imparting agents, iron oxide, manganese oxide and titanium carbide are preferably used as the conductivity imparting agent that enables the production of black ceramics. Examples of the blackish conductivity imparting agent that can be added to for example, zirconia ceramics or the conductivity imparting agent that can be used for providing the dark color tone therewith even if the ceramics have the brownish or bluish color tone, include iron oxide, titanium oxide, chromium oxide, cobalt oxide, and nickel oxide. Of these conductivity imparting agents, iron oxide and chromium oxide are preferably used as the conductivity imparting agent that enables the production of black ceramics. Silicon carbide ceramics containing carbon as the conductivity agent are preferably used as black ceramics.

Furthermore, ceramics used for the vacuum suction nozzle 1 of the present invention are preferably zirconia ceramics containing a stabilizing agent.

It is preferable to use zirconia ceramics containing a stabilizing agent used for the vacuum suction nozzle 1 because a mechanical strength of the ceramics is increased by using zirconia ceramics that contain a stabilizing agent. Particularly in the case of vacuum suction nozzle 1 having the cylindrical portion 5 of small diameter as the vacuum suction nozzle 1 shown in Fig. 1(a), when the electronic component 15 suctioned onto the suction surface 2 is mounted on a circuit board, an adjacent component and the tip end portion of the vacuum suction nozzle 1 may collide and damage the cylindrical portion 5. Therefore, it is preferable to use zirconia that has high strength and contains a stabilizing agent.

The stabilizing agent added to the zirconia ceramics may be yttria, ceria, magnesia or the like. Zirconia having sufficiently high strength for practical use can be obtained by containing about 2 to 8 mol% of such a stabilizing agent. The mean crystal grain size of zirconia is preferably not more than 1 µm. In case that zirconia having a mean crystal grain size of not more than 1 µm is used, crystal grains become less likely to come off and therefore the suction surface 2 is less likely to chip off, when the suction surface 2 is subject to grounding process or mirror-finish polishing process during a manufacture or a repair of the vacuum suction nozzle 1. In particular, the mean crystal grain size of zirconia is more preferably not less than 0.3 µm nor more than 0.8 µm.

It is also preferable that the vacuum suction nozzle 1 of the present invention is formed from zirconia ceramics containing a stabilizing agent wherein at least one kind of iron oxide, titanium oxide, chromium oxide and cobalt oxide is contained as the conductivity imparting agent. The conductivity imparting agent can not only render electrical conductivity to the zirconia ceramics but also give a color to the ceramics such as blackish color with iron oxide, yellowish color with titanium oxide, greenish color with chromium oxide, and bluish color with cobalt oxide.

Mean crystal grain size of the conductivity imparting agent is preferably no less than 0.5 µm nor more than 3 µm. While the inner surface of the suction orifice 3 of the vacuum suction nozzle 1 has been case-hardened and crystal grains of the conductivity imparting agent appear as the protrusions 7 on the case-hardened surface, the surface roughness (arithmetic mean roughness Ra) of the inner surface of the suction orifice 3 can be controlled to not more than 0.5 µm when the mean crystal grain size of the conductivity imparting agent is not less than 0.5 µm nor more than 3 µm. Moreover, when mean crystal grain size of the conductivity imparting agent is in a range from 0.5 to 3 µm, the surface roughness (maximum height Rmax) can be controlled in a range from 0.6 to 5.5 µm. Thus it is made possible to decrease the possibility of foreign matters deposited on the inner surface of the suction orifice and so as to suppress the suction force from decreasing, thus decreasing a failure of picking up the electronic component 15.

When the electronic component 15 is suctioned by the vacuum suction nozzle 1, the light 17 directs light to the electronic component 15 suctioned by the vacuum suction nozzle 1, and the CCD camera 18 receives a reflected light, while dark color tone can be selected for the vacuum suction nozzle 1 against the color tone of the electronic components 15. As a result, the vacuum suction nozzle 1 and the electronic component 15 can be rendered with color tones that are easily distinguished by an image analyzing apparatus 19, so that a recognition error and a malfunction can be reduced.

In general, the electronic component 15 usually has white, silver or grey color, and therefore the vacuum suction nozzle 1 is often required to have dark color tone such as black. In order to make the vacuum suction nozzle 1 having dark color tone, it is preferable to use zirconia ceramics containing 65% by mass of zirconia, 30% by mass of iron oxide, 3% by mass of cobalt oxide and 2% by mass of chromium oxide. When the electronic component 15 has silver color, it is preferable that the vacuum suction nozzle 1 has dark blackish color which can be obtained by containing not less than 25% by mass iron oxide.

Moreover, in case that the vacuum suction nozzle 1 of the present invention is formed from high-strength zirconia ceramics that contain a stabilizing agent, strength tends to decrease when the ceramics is sintered to react with the conductivity imparting agent that is contained for a purpose of rendering a black color and electrical conductivity. In order to suppress a strength from decreasing, it is preferable to quench the ceramics by blowing air into the furnace so that the sintered ceramics are quickly cooled down from a high temperature around 1,000°C to around 400°C in 1 hour. In this case, multitude of protrusions 7 of very low height can be formed on the surface of the suction orifice 3 that is difficult to quench by the oxide conductivity imparting agent such as iron oxide, titanium oxide or chromium oxide that is apt to precipitate. The protrusions 7 can be formed in a semi-spherical shape due to the surface tension of the oxide conductivity imparting agent such as iron oxide, titanium oxide or chromium oxide that precipitates in air atmosphere.

A method for manufacturing vacuum suction nozzle 1 made of ceramics of the present invention will be described below.
It is possible to use, as ceramics that constitute the vacuum suction nozzle 1 of the present invention, known materials such as silicon carbide, alumina, and zirconia containing a stabilizing agent.

For example, a material obtained by mixing 95% by mass of silicon carbide with 5% by mass of aluminum as a sintering aid is charged into a ball mill and crushed to a predetermined grain size to prepare a slurry, which is then spray-dried using a spray dryer to form granular materials.

Next, granular materials and a thermoplastic resin are charged into a kneader and kneaded while heating to obtain a green body, which is then charged into a pelletizer to obtain pellets that would be turned into a material for injection molding. As the thermoplastic resin to be charged into the kneader, an ethylene-vinyl acetate copolymer, polystyrene or an acrylic resin may be added in the proportion of about 10 to 25% by mass based on the mass of ceramics, and the heating temperature during kneading using the kneader may be set within a range from 140 to 180°C. The kneading conditions may be appropriately set according to the kind or grain size of ceramics, and the kind of the thermoplastic resin.

The pellets obtained as described above are charged into an injection molding machine and subjected to injection molding operation, to obtain a green compact that would be turned into the vacuum suction nozzle 1. As the green compact has a runner formed from excessive material that has solidified during injection the molding process, the green compact is cut off before degreasing.

Conditions of sintering silicon carbide may be as follows. Silicon carbide ceramics may be sintered at maximum temperature that is set in a range from 1,900°C to 2,200°C, and the maximum temperature is held for a period of 1 to 5 hours in vacuum atmosphere or inactive gas atmosphere such as argon or helium. In order to form the protrusions 7, a low temperature (1,000°C to 1,300°C) may be held for a predetermined period of time (about one hour) when raising the temperature.

Furthermore, when zirconia ceramics and alumina ceramics each containing a stabilizing agent are used as ceramics that constitute the vacuum suction nozzle 1 of the present invention, it is possible to use, as the conductivity imparting agent, at least one kind of iron oxide, cobalt oxide, chromium oxide and nickel oxide, or those containing titanium carbide or titanium nitride.

For example, 65% by mass of zirconia containing yttria as a stabilizing agent is mixed with 35% by mass of iron oxide and the obtained material is charged into a ball mill and then crushed to a predetermined grain size to prepare a slurry. Using a spray dryer, the slurry is spray-dried to form granular materials, which are then charged into an injection molding machine, injection-molded in the same manner as described above and sintered to obtain a green compact that would be turned into a vacuum suction nozzle 1.

Sintering conditions for zirconia ceramics and alumina ceramics may be as follows. When at least one kind of iron oxide, cobalt oxide, chromium oxide and titanium oxide is contained as the conductivity imparting agent, the material may be sintered with maximum temperature set in a range from 1,300°C to 1,500°C, while keeping the maximum temperature for a period of 1 to 5 hours in air atmosphere. During the cooling period, the temperature is lowered from a high temperature around 1,000°C to around 400°C within one hour. This procedure makes it possible to form multitude of protrusions 7 of very low height on the surface of the suction orifice 3 that is difficult to quench, by an action of the oxide conductivity imparting agent such as iron oxide, titanium oxide or chromium oxide that is apt to precipitate. When titanium carbide is used as the conductivity imparting agent, the material may be sintered with maximum temperature set in a range from 1,400°C to 1,800°C, while keeping the maximum temperature for a period of 1 to 5 hours. In order to form the protrusions 7, a low temperature (1,000°C to 1,300°C) may be held for a predetermined period of time (about one hour) when raising the temperature, followed by sintering in vacuum or inactive gas atmosphere such as argon. When titanium nitride is used as the conductivity imparting agent, the material may be sintered in nitrogen atmosphere, instead of vacuum or inactive gas atmosphere. Thus a moderate level of electrical conductivity can be given to the vacuum suction nozzle 1 that is formed from ceramics. Examples

### (Example 1)

Examples of a vacuum suction nozzle of the present invention will be described below.

First, zirconia containing 3 mol % of yttria as a stabilizing agent was selected as ceramics. Then, water was added to raw materials of 100 parts by mass of zirconia and 10 parts by mass of iron oxide as a conductivity imparting agent added to zirconia, followed by crushing and mixing in a ball mill to prepare a slurry. The obtained slurry was spray-dried to prepare granular materials. To the raw materials, a sintering aid such as magnesia, calcia, titania or zirconia was appropriately added upon weighing.

An ethylene-vinyl acetate copolymer, polystyrene and an acrylic resin were added in the total proportion of 20% by mass based on 100% by mass of the granular materials. The mixture was charged into a kneader and kneaded while maintaining at the temperature of about 150°C to prepare a green body. Then, the obtained green body was charged into a pelletizer to prepare pellets that are used as materials for injection molding. The obtained pellets were charged into a known injection molding machine to prepare a green compact and the green compact was put in a dryer and then dried. Using a known common method of sintering ceramics, a green compact, that would be turned into a vacuum suction nozzle 1 as an example shown in Fig. 1, was made. The green compact was sintered under the following sintering conditions. That is, the green compact was sintered with maximum temperature set in a range from 1,300 to 1,500°C while keeping the maximum temperature for a period of 1 to 5 hours in air atmosphere. Cooling air was injected into the furnace when the temperature reached 1,000°C so as to enable quick cooling from 1,000 to 400°C in 1 hour upon cooling after sintering. The obtained sintered body was subjected to barrel polishing operation to remove the surface ceramics to a depth of several micrometers. And then a flat surface was formed by grinding a portion, that would become the suction surface 2, of the vacuum suction nozzle 1. The sintered body was processed to obtain a vacuum suction nozzle 1 having cylindrical portion 5 measuring 3.2 mm in length and 0.15 to 0.25 mm in wall thickness and measuring 0.7 mm in outer diameter and 0.20 to 0.4 mm in inner diameter. These vacuum suction nozzles are referred to as specimens Nos. 2 to 8 and 10 to 17 of Examples of the present invention.

The height of the protrusion 7 was determined by observing the inside of the suction orifice 3 under a tool microscope of 100 magnifying power with the vacuum suction nozzle 1 placed so that the suction surface 2 faced upward, and measuring the height difference between the highest point of the protrusion 7 and the bottom of the inner surface of the suction orifice 3 at 10 points arbitrarily picked. Mean value of the measurements was taken as the height of the protrusions 7 formed on the surface of the suction orifice 3. The height of the protrusions 7 was controlled by adjusting the length of cooling period in which the temperature was quickly lowered from a high temperature around 1,000°C to around 400°C in the case of sintering in air atmosphere.

A specimen without the protrusion 7 on the inner surface of the suction orifice 3 was made as specimen out of the scope of the present invention. The specimen without the protrusion 7 was made by using the material of the same composition and the same manufacturing method as described above, except for employing spontaneous cooling instead of quickly cooling from a high temperature around 1,000°C to around 400°C during sintering. This is referred to as specimen No. 19 of Comparative Example of the present invention.

Then the specimens of the vacuum suction nozzle 1 were installed on the electronic component mounting machine 14, and vacuum suction test of the electronic components 15 was conducted to investigate the failure of mounting the electronic components 15 and suction force of the vacuum suction nozzle 1. The vacuum suction test was conducted by using the electronic components 15 of type 0603 (measuring 0.6 mm by 0.3 mm) and evaluating a decrease in the suction force when grit and dust and solder fragments of electrodes formed on the surface of the electronic component 15 deposited on the inner surface of the suction orifice 3. The distance between adjacent electronic components 15 was set to 0.1 mm at the minimum.

Failure of mounting the electronic component 15 was tested by operating the electronic component mounting machine 14 to suction twenty million pieces and mount the electronic components 15 on a dummy circuit board, and counting the number of incidents in which the electronic components 15 overwrapped each other without being disposed neatly, thereby determining the number of the electronic components 15 which failed to be mounted. The result was indicated with "A" when the number of the electronic components 15 that were not mounted at all or overwrapped each other without being disposed neatly was not more than 3, "B" when the number was not less than 4 nor more than 10, and "C" meaning not acceptable, when the number of the electronic components 15 that were not mounted at all or overwrapped each other without being disposed neatly was not less than 11, since this was identical to or worse than the conventional nozzle.

Suction force of the vacuum suction nozzle 1 was tested by operating the electronic component mounting machine 14 to suction twenty million pieces, followed by continuous mounting test of 100 pieces. The result was indicated with "A" when 100 electronic components 15 could be continuously picked up without positional deviation, "B" when 100 electronic components 15 could be continuously picked up with a little positional deviation observed, and "C" meaning not acceptable when 100 electronic components 15 could not be continuously picked up with the electronic components 15 dropping, since this was identical to or worse than the conventional nozzle. The results are shown in Table 1.

**Table 1**

| Specimen No. | Shape of suction orifice inner surface | | | Mounting failure | Suction force |
|---|---|---|---|---|---|
| | Diameter of suction orifice (µm) | Presence of protrusions having low electrical resistance | Height of protrusion (µm) | | |
| *1 | 200 | Absent | 0 | C | C |
| 2 | 200 | Present | 0.7 | A | A |
| 3 | 200 | Present | 5.9 | A | A |
| 4 | 200 | Present | 10.6 | A | A |
| 5 | 200 | Present | 19.9 | A | A |
| 6 | 200 | Present | 22.1 | A | B |
| 7 | 200 | Present | 30.0 | A | B |
| 8 | 200 | Present | 35.3 | B | B |
| *9 | 300 | Absent | 0 | C | C |
| 10 | 300 | Present | 8.2 | A | A |
| 11 | 300 | Present | 17.9 | A | A |
| 12 | 300 | Present | 21.8 | A | A |
| 13 | 300 | Present | 30.0 | A | A |
| 14 | 300 | Present | 31.3 | B | B |
| 15 | 300 | Present | 39.1 | B | B |
| 16 | 400 | Present | 29.8 | A | A |
| 17 | 400 | Present | 41.6 | B | B |

| | | | | | |
|---|---|---|---|---|---|
| Specimen marked with * is out of the scope of the present invention. | | | | | |

With respect to the mounting failure of the electronic component 15 and the suction force, it is found that specimens Nos. 2 to 8 and 10 to 17 of Examples of the vacuum suction nozzle of the present invention failed to mount not more than 10 pieces and showed no dropping in suction force from the results shown in Table 1. In contrast, specimen No. 19 of Comparative Examples of the present invention failed to mount not less than 11 pieces and could not continuously pick up with some electronic components dropping. Thus it was proved that Examples of the present invention are better than Comparative Examples. That is to say, usually, foreign matters such as grit and dust contained in the atmosphere and solder fragments are taken into the suction orifice together with air, and the foreign matters are charged with the static electricity when the electronic component is suctioned by vacuum suction. As a result, such foreign matters deposit on the inner surface of the suction orifice and decrease the suction force of the vacuum suction nozzle 1. However, since a plurality of protrusions having an electrical resistance lower than that of the main component of the ceramics are formed on the inner surface of the suction orifice 3 of specimens Nos. 2 to 8 and 10 to 17 of the present invention, the static electricity of the foreign matters is discharged through the vacuum suction nozzle 1 to the electronic component mounting apparatus 20 when the foreign matters touches the protrusions 7 formed on the inner surface of the suction orifice 3. As a result, foreign matters such as grit and dust contained in the atmosphere and solder fragments hardly deposit on the inner surface of the suction orifice 3 by the static electricity. In contrast, in specimen No. 19 of Comparative Example, the protrusions 7 of low electrical resistance are not formed on the inner surface of the suction orifice 3 of the vacuum suction nozzle 1, and therefore grit and dust and solder fragments tended to deposit on the inner surface of the suction orifice 3, and failed to mount not less than 11 pieces due to clogging of the suction orifice 3 and could not continuously pick up with some electronic components dropping, thus showing performance identical to or worse than the conventional nozzle.

Among Examples of the present invention, the number of mounting failures was not more than 3 with specimens Nos. 2 to 7, 10 to 13 and 16 where the height of the protrusions 7 was not more than 30 µm, while the number of mounting failures was 4 to 10 with specimens Nos. 8, 14, 15 and 17 where the height of the protrusions 7 was not less than 30 µm, indicating that the height of the protrusions 7 is preferably not more than 30 µm. Specifically, in specimens Nos. 2 to 7, 10 to 13 and 16 where the height of the protrusions 7 was not more than 30 µm, even when foreign matters measuring not more than several tens of micrometers, which is the ordinary size of grit and dust contained in the atmosphere and solder fragments of electrodes, are taken into the suction orifice 3, the foreign matters can move over the protrusions 7 and roll over, and are not likely to be caught on the inner surface of the suction orifice 3. As a result, it is supposed that the foreign matters are not likely to deposit on the inner surface of the suction orifice 3, thereby allowing the suction orifice 3 to stably suction and mount the electronic components 15 without being clogged.

Among Examples of the present invention, in specimens Nos. 2 to 5, 10 to 13 and 16 where the height of the protrusions 7 was not more than 10% of the diameter of the suction orifice 3, the air flowing through the suction orifice 3 received lower resistance when the air is taken into the suction orifice 3 for vacuum suction of the electronic components 15. As a result, it is supposed that suction force did not decrease and solder fragments and general grits and dusts contained in air did not accumulate so that sufficient suction force was stably obtained.

### (Example 2)

Next, specimens were made so as to confirm a difference in a failure of mounting due to a shape of the protrusions 7 and a difference in the failure of mounting due to the conductivity imparting agent. First, ceramics used in Example 1, that is, ceramics containing, as a main component, zirconia containing 3 mol % of yttria as a stabilizing agent were used. The same processes were used until a green compact is formed from ceramics containing, as conductivity imparting agents, iron oxide, titanium oxide, cobalt oxide, chromium oxide, nickel oxide and titanium carbide in each proportion of 22% by mass added therein. When the conductivity imparting agents are iron oxide, titanium oxide, cobalt oxide and chromium oxide, the green compact was sintered under the following sintering conditions. That is, the green compact was sintered with maximum temperature set in a range from 1,300 to 1,500°C while keeping the maximum temperature for a period of 1 to 5 hours in air atmosphere. Cooling air was injected into a furnace when the temperature reached 1,000°C so as to enable quick cooling from 1,000 to 400°C in 1 hour upon cooling after sintering to make specimens. The obtained specimens are referred to as specimens Nos. 18 to 21 of Examples of the present invention. When the conductivity imparting agent is nickel oxide, the green compact was sintered with maximum temperature set at 1,340°C while keeping the maximum temperature for 2 hours in air atmosphere. Cooling air was injected into the furnace when the temperature reached 1,000°C so as to enable quick cooling from 1,000 to 400°C in 1 hour upon cooling after sintering to make specimens. The obtained specimen is referred to as specimen No. 22. When the conductivity imparting agent is titanium carbide, the green compact was sintered with maximum temperature set at 1,300°C while keeping the maximum temperature for 15 hours in vacuum atmosphere, after keeping at 1,000°C (for 1 hour) during raising of the temperature to make specimens. The obtained specimen is referred to as specimen No. 23.

The sintered body was subjected to barrel polishing operation to remove the surface ceramics to a depth of several micrometers, followed by grinding operation to form flat surface in the portion of the vacuum suction nozzle that would become the suction surface 2. The vacuum suction nozzle 1 was made having the cylindrical portion 5 measuring 3.2 mm in length and 0.15 mm in wall thickness and measuring 0.7 mm in outer diameter and 0.40 mm in inner diameter. Configuration of the protrusions 7 was checked on a photograph taken with SEM (scanning electron microscope) with magnifying power of 1000. Configuration of the protrusions 7 is schematically shown in Fig. 5(X) to Fig. 5(Z). Fig. 5(X) shows a semi-spherical shape, Fig. 5(Y) shows a crater-like shape and Fig. 5(Z) shows a chevron shape.

Then the vacuum suction nozzles 1 were installed on the electronic component mounting machine 14, and vacuum suction test of the electronic components 15 was conducted by mounting thirty million pieces of the electronic components 15 of type 0603 (measuring 0.6 mm by 0.3 mm) to further closely investigate the failure of mounting the electronic components 15. The distance between adjacent electronic components 15 was set to 0.1 mm at the minimum.

The result was indicated with "A" when mounting failure did not occur at all among the thirty million pieces, "B" when only one mounting failure occurred between twenty millionth through thirty millionth pieces, and "C" when two to three mounting failures occurred between twenty millionth through thirty millionth pieces. The results are shown in Table 2.

**Table 2**

| Specimen No. | Type of conductivity imparting agent | Presence of protrusion | Shape of protrusion | Amounting failure |
|---|---|---|---|---|
| 18 | Iron oxide | Present | Semi-spherical shape | A |
| 19 | Titanium oxide | Present | Semi-spherical shape | A |
| 20 | Chromium oxide | Present | Semi-spherical shape | A |
| 21 | Cobalt oxide | Present | Semi-spherical shape | A |
| 22 | Nickel oxide | Present | Crater-like shape | B |
| 23 | Titanium carbide | Present | Chevron shape | C |

As is apparent from the results shown in Table 2, while no mounting failure occurred till the thirty millionth piece with specimens Nos. 18 to 21 in which the protrusions 7 had a semi-spherical shape among Examples of the present invention, specimens Nos. 22 and 23 that were Examples of the present invention in which the protrusions 7 had a crater-like or a chevron shape were evaluated as "C" or "B". Thus it can be seen that the protrusions 7 preferably has a semi-spherical. Specifically, in specimens Nos. 18 to 21 in which the protrusions 7 had a semi-spherical among the Examples of the present invention, foreign matters such as grit, dust and solder fragments that were trapped during vacuum suctioning, move over the protrusions 7 and were suppressed from depositing on the inner surface of the suction orifice 3. Therefore, the protrusions 7 can be easily formed in a semi-spherical shape by using iron oxide, titanium oxide, cobalt oxide or chromium oxide as the conductivity imparting agent. This makes it easier for the foreign matters such as grit, dust and solder fragments that were trapped during vacuum suctioning to move over the protrusions 7 and roll over, thus effectively suppressing the foreign matters from depositing on the inner surface of the suction orifice 3.

### (Example 3)

Next, specimens were made so that a change in the situation of the generation of the electrostatic breakdown of the electronic components and blow-off objects is confirmed by electrical resistance between the tip end and the root of the vacuum suction nozzle 1. First, silicon carbide was selected as ceramics and then mixed with 91 to 95o by mass of silicon carbide, 5% by mass of alumina as a sintering aid and 0.2 to 4% by mass of carbon as a conductivity imparting agent. Then, water was added to the mixture, followed by crushing and mixing in a ball mill to prepare a slurry. The obtained slurry was spray-dried using a spray dryer to prepare granular materials. An ethylene-vinyl acetate copolymer, polystyrene and an acrylic resin were added in the total proportion of 20% by mass based on 100% by mass of the granular materials. The mixture was charged into a kneader and kneaded while maintaining at the temperature of about 150°C to prepare a green body. Then, the obtained green body was charged into a pelletizer to prepare pellets that are used as materials for injection molding. The obtained pellets were charged into a known injection molding machine to prepare a green compact that would be turned into a vacuum suction nozzle 1 as shown in Fig. 1.

These green compacts were put into a dryer of nitrogen atmosphere to dry, and was sintered in known argon atmosphere to make a sintered body. That is, in heating up, temperature was held within a low temperature region (1,000°C to 1,300°C) for a predetermined period of time (about 1 hour), and then maximum temperature set in a range from 1,900°C to 2,200°C was held for a period of 1 to 5 hours to make a sintered body by sintering. The obtained sintered body was subjected to barrel polishing operation to remove the surface ceramics to a depth of several micrometers. Then, the portion of the vacuum suction nozzle that would be turned into the suction surface 2 of the vacuum suction nozzle 1 was ground to be flat. The vacuum suction nozzle 1 was formed wherein its cylindrical portion 5 has sizes of 3.2 mm in length and 0.15 mm in wall thickness, 0.7 mm in outer diameter and 0.4 mm in inner diameter. These specimens are referred to as Nos. 24 to 28.

Next, alumina, zirconia containing 3 mol % of yttria as a stabilizing agent and silicon carbide were selected as ceramics. Subsequently, a raw material prepared by adding iron oxide, cobalt oxide, chromium oxide, nickel oxide, titanium carbide and carbon as conductivity imparting agents in the proportion in a range from 0.2 to 50 parts by mass based on 100 parts by mass of the total of ceramics and the conductivity imparting agents, and a raw material containing no conductivity imparting agent added therein were respectively weighed. Then, water was added to these raw materials, followed by crushing and mixing in a ball mill to prepare a slurry. The obtained slurry was spray-dried using a spray dryer to prepare granular materials. To the raw materials, a sintering aid such as magnesia, calcia, titania or zirconia was appropriately added upon weighing.

Green compacts were made by the injection molding method described above, and these green compacts were dried in a dryer. Then, when the conductivity imparting agent was at least one kind of iron oxide, cobalt oxide, chromium oxide and nickel oxide, the material was sintered by the common method of sintering ceramics with a maximum temperature set in a range from 1,300°C to 1,500°C, while keeping the maximum temperature for a period of 1 to 5 hours in air atmosphere. During the cooling period after sintering, cooling air was blown into the furnace when the temperature reached 1,000°C, so that the material could be quickly cooled down from 1, 000°C to around 400°C in one hour. When the conductivity imparting agent was titanium carbide, the material was sintered by holding a low temperature (1,000°C to 1,300°C) for a predetermined period of time (about one hour), then holding maximum temperature set in a range from 1,400°C to 1,800°C for a period of 1 to 5 hours in argon atmosphere to make sintered material. The sintered body was subjected to barrel polishing operation to remove the surface ceramics to a depth of several micrometers. Then the portion of the vacuum suction nozzle that would become the suction surface 2 of the vacuum suction nozzle 1 was ground to be flat. The vacuum suction nozzle 1 was formed wherein its cylindrical portion 5 has sizes of 3.2 mm in length and 0.15 mm in wall thickness, 0.7 mm in outer diameter and 0.4 mm in inner diameter. These specimens are referred to as Nos. 29 to 43.

Then these specimens of the vacuum suction nozzle 1 were installed on the electronic component mounting machine 14, and subjected to vacuum suction test of the electronic components 15 of type 0603 (measuring 0.6 mm by 0.3 mm), to check for blow-off of the electronic components 15 and the electrostatic breakdown of the electronic components 15. The distance between adjacent electronic components 15 was set to 0.1 mm at the minimum.

Blow-off of the electronic component 15 was checked by operating the electronic component mounting machine 14 to suction twenty million pieces and counting the electronic components 15 on a dummy circuit board, thereby to determine the number of the electronic component 15 that were blown off. The result is indicated with "A" when not more than three pieces were blown off, "B" when four to ten pieces were blown off, and "C" when not less than 11 pieces were blown off since this was identical to or worse than the conventional vacuum suction nozzle.

The electrostatic breakdown of the electronic component 15 was checked as follows. The electronic component mounting machine 14 was operated to suction twenty million pieces and mounting the electronic components 15 on a dummy circuit board where circuit had been formed, and continuity test was conducted for the dummy circuit board to see whether current flows through the circuit or not, thereby determining whether the electrostatic breakdown of the electronic component 15 occurred or not. In this test, 100 electronic components 15 were mounted on one dummy circuit board, and continuity test was conducted for each dummy circuit board by using a commonly used circuit continuity tester. On a dummy circuit board which did not show continuity, the continuity of the individual electronic components 15 mounted thereon was tested and the number of electronic components 15 that failed due to the electrostatic breakdown was counted. The result is indicated with "A" when not more than three pieces suffered the electrostatic breakdown, "B" when four to eight pieces suffered the electrostatic breakdown, and "C" when nine to ten pieces suffered the electrostatic breakdown. The results are shown in table 3.

**Table 3**

| Specimen No. | Ceramic material | Electrical resistance between the tip end and the root (Ω) | Conductivity imparting agent | | | | | | | Sintering aid | Etectrostatic breakdown | Blown-off object |
|---|---|---|---|---|---|---|---|---|---|---|---|---|
| | | | Total conductivity imparting agent | Iron oxide | Cobalt oxide | Chromium oxide | Nickel oxide | Titanium carbide | Carbon | | | |
| | | | (% by weight) | | | | | | | | | |
| 24 | Silicon carbide | 10⁶ | 0 | 0 | 0 | 0 | 0 | 0 | <0.1 | 5 | A | A |
| 25 | Silicon carbide | 10⁵ | 0.2 | 0 | 0 | 0 | 0 | 0 | 0.2 | 5 | A | A |
| 26 | Silicon carbide | 10⁴ | 1 | 0 | 0 | 0 | 0 | 0 | 1 | 5 | A | A |
| 27 | Silicon carbide | 10³ | 3 | 0 | 0 | 0 | 0 | 0 | 3 | 5 | A | A |
| 28 | Silicon carbide | 10² | 4 | 0 | 0 | 0 | 0 | 0 | 4 | 5 | C | A |
| 29 | Alumina | 10¹² | 0 | 0 | 0 | 0 | 0 | 0 | 0 | 0.5 | B | C |
| 30 | Alumina | 10¹¹ | 3 | 0 | 0 | 0 | 0 | 3 | 0 | 1 | B | B |
| 31 | Alumina | 10¹⁰ | 5 | 0 | 0 | 0 | 0 | 5 | 0 | 1 | A | A |
| 32 | Alumina | 10⁶ | 8 | 0 | 0 | 0 | 0 | 8 | 0 | 2 | A | A |
| 33 | Alumina | 10³ | 13 | 0 | 0 | 0 | 0 | 13 | 0 | 4 | A | A |
| 34 | Alumina | 10³ | 15 | 0 | 0 | 0 | 0 | 15 | 0 | 5 | A | A |
| 35 | Alumina | 10² | 17 | 0 | 0 | 0 | 0 | 17 | 0 | 5 | C | A |
| 36 | Alumina | 10⁻³ | 20 | 0 | 0 | 0 | 0 | 20 | 0 | 7 | C | A |
| 37 | Zirconia | 10¹² | 0 | 0 | 0 | 0 | 0 | 0 | 0 | 0 | B | C |
| 38 | Zirconia | 10¹¹ | 28 | 23 | 2 | 2 | 1 | 0 | 0 | 0 | A | B |
| 39 | Zirconia | 10¹⁰ | 32 | 27 | 2 | 2 | 1 | 0 | 0 | 0 | A | A |
| 40 | Zirconia | 10⁷ | 35 | 30 | 2 | 2 | 1 | 0 | 0 | 0 | A | A |
| 41 | Zirconia | 10⁵ | 41 | 36 | 2 | 2 | 1 | 0 | 0 | 0 | A | A |
| 42 | Zirconia | 10³ | 45 | 40 | 2 | 2 | 1 | 0 | 0 | 0 | A | A |
| 43 | Zirconia | 10² | 50 | 45 | 2 | 2 | 1 | 0 | 0 | 0 | C | A |

As is apparent from the results shown in Table 3, specimens Nos. 24 to 27, 30 to 34 and 38 to 42 of Examples of the vacuum suction nozzle of the present invention experienced the blow-off and the electrostatic breakdown of not more than eight electronic components 15 out of twenty million pieces, better than specimens Nos. 28, 29, 35 to 37 and 43 of Examples of the present invention and experienced the blow-off and the electrostatic breakdown of nine or ten electronic components 15. This is because specimens Nos. 24 to 27, 30 to 34 and 38 to 42, among Examples of the present invention, which had electrical resistance of 10³ Ω to 10¹¹ Ω between the front end and rear end of the vacuum suction nozzle 1 and were therefore capable of quickly discharging the static electricity charged on the vacuum suction nozzle 1, thus resulting in almost no electronic component 15 being blown off by the static electricity or suffering the electrostatic breakdown.

While silicon carbide, alumina or zirconia was used as the ceramics in the present Example, it was found that all specimens Nos. 24 to 27, 30 to 34 and 38 to 42 which used these materials had electrical resistance of 10³ Ω to 10¹¹ Ω between the tip end and the root of the vacuum suction nozzle 1 and were therefore capable of significantly suppressing the electronic component 15 from being blown off by the static electricity or suffering the electrostatic breakdown.

The above discussion shows that, when the vacuum suction nozzle 1 of the present invention is installed on the electronic component mounting machine and the electronic component mounting apparatus 20 is operated, the static electricity is discharged through the protrusions 7 formed in the suction orifice 3 when the electronic component 15 is suctioned, so that there is no influence of the electrostatic charge when the electronic component 15 is suctioned by the vacuum suction nozzle 1. Thus it was confirmed that the electronic component 15 is prevented from being blown off by the repulsive force of the static electricity of the vacuum suction nozzle 1. It is also made possible to suppress the electrostatic breakdown from being caused by the discharge to the electronic component 15, and suppress an accumulation of the electrostatic charge on the inner surface of the suction orifice 3. As a result, since foreign matters such as grit, dust contained in the atmosphere and solder fragments of electrodes formed on the surface of the electronic component 15 are suppressed from depositing on the inner surface of the suction orifice 3, it was confirmed that suction failure and mounting failure of the electronic component 15 are mostly eliminated.

### (Example 4)

Effect of difference in the surface roughness (arithmetic mean roughness Ra and maximum height Rmax) of the inner surface of the suction orifice 3 of the vacuum suction nozzle 1 on the suction failure of the electronic component 15 and dropping of the electronic component 15 was confirmed.

Specimens were made by using ceramics containing the same main composition of the vacuum suction nozzle 1, the conductivity imparting agent of the same composition, the same method of molding the green compact and the same method of sintering the green compact as those of Example 1, while changing the particle size of the powder material and the maximum temperature of sintering, so as to form the inner surface of the suction orifice 3 of the vacuum suction nozzle 1 having desired surface roughness (arithmetic mean roughness Ra and maximum height Rmax). Sizes of the cylindrical portion 5 of the vacuum suction nozzlel were 3.2 mm in length and 0.25 mm in wall thickness and measuring 0.7 mm in outer diameter and 0.20 mm in inner diameter.

Zirconia powder having particle size in the range from 0.2 to 0.3 µm and conductivity imparting agent powder having particle size in the range from 0.2 to 0.4 µm were used to make the specimens with the inner surface of the suction orifice 3 of the vacuum suction nozzle 1 having desired surface roughness (arithmetic mean roughness Ra and maximum height Rmax) by sintering with the maximum temperature shown in Table 4.

The surface roughness (arithmetic mean roughness Ra and maximum height Rmax) of the inner surface of the suction orifice 3 was determined by cutting the vacuum suction nozzle 1 along the axial direction into two roughly equal halves by a laser cutter, and measuring the surface roughness of one half.

A surface roughness meter (Taylor Hobson's TalySurf S4C surface roughness meter) was used to measure the surface roughness of the inner surface of the suction orifice 3 in the axial direction of the vacuum suction nozzle 1, with measuring length set to 4.8 mm, cutoff value of 0.8 mm and probe diameter 5 µm. Ten measurements were taken and averaged.

The specimens were evaluated by the following procedures. First, the vacuum suction nozzle 1 of each specimen was installed on the electronic component mounting machine 14 to suction twenty million pieces and mount the electronic components 15 of type 0603. Then suction force of the vacuum suction nozzle 1 was checked by continuous mounting test of 100 pieces. The result is indicated with "A" when 100 electronic components 15 could be consecutively picked up without positional deviation, "B" when suctioning operation could be continued with a little positional deviation observed in one to five electronic components 15, "C" when suctioning operation could be continued with a little positional deviation observed in six to ten electronic components 15, and "D" when suctioning operation could be continued with a little positional deviation observed in not less than 11 electronic components 15 dropped and suctioning operation could not be continued, or suctioning operation could not be continued with one or more electronic components 15 dropped from the nozzle.

Test to examine the change in suction force of the electronic component mounting machine 14 was conducted three times. In the first test, twenty million pieces of the electronic components 15 were picked up with suction force of 100 kPa, then suction force was checked by picking up 100 pieces of the electronic components 15 with suction force of 100kPa. Then the specimens were removed from the electronic component mounting machine 14, subjected to ultrasonic cleaning for 30 minutes in pure water, dried and subjected to the second suction test. In the second test, the specimens were again installed on the electronic component mounting machine 14, and twenty million pieces of the electronic components 15 were picked up similarly to the first test, with suction force of 60 kPa, followed by suction test of 100 electronic components 15 with suction force of 60 kPa. The condition of 60 kPa, which is lower than the commonly set value of the suction force, was added because thin chips that are recently prevalent tend to be damaged by high vacuum, and there is a trend toward lower suction force to be employed in order to shorten the time taken to cancel the suctioning operation for the purpose of reducing the mounting time of the electronic components 15.

After the second suction test, in order to determine whether positional deviation or drop-off the electronic components 15 in the test described above was caused by the deposition of grit, dust and solder fragments on the inner surface of the suction orifice 3 or not, each specimen was cleaned again, installed on the electronic component mounting machine 14, and the third test was conducted in which 100 pieces of the electronic components 15 were picked up with suction force of 60 kPa. The results are shown in Table 4.

**Table 4**

| Specimen No. | Sintering temperature | Surface roughness | | Suction force | | |
|---|---|---|---|---|---|---|
| | | Arithmetic mean roughness Ra (µm) | Maximum height Rmax (µm) | First test | Second test | Third test |
| | (°C) | | | Suction force 100 kPa | Suction force 60 kPa | Suction force 60 kPa |
| 101 | 1280 | 0.05 | 0.48 | B | C | A |
| 102 | 1290 | 0.05 | 0.60 | A | B | A |
| 103 | 1300 | 0.05 | 0.66 | A | B | A |
| 104 | 1350 | 0.05 | 2.00 | A | B | A |
| 105 | 1400 | 0.05 | 4.80 | A | B | A |
| 106 | 1440 | 0.05 | 5.50 | A | B | A |
| 107 | 1460 | 0.05 | 5.90 | B | C | A |
| 108 | 1280 | 0.06 | 0.48 | B | C | A |
| 109 | 1290 | 0.06 | 0.60 | A | B | A |
| 110 | 1300 | 0.06 | 0.66 | A | A | A |
| 111 | 1350 | 0.06 | 2.00 | A | A | A |
| 112 | 1400 | 0.06 | 4.80 | A | A | A |
| 113 | 1440 | 0.06 | 5.50 | A | B | A |
| 114 | 1460 | 0.06 | 5.90 | B | C | A |
| 115 | 1280 | 0.45 | 0.48 | B | C | A |
| 116 | 1290 | 0.45 | 0.60 | A | B | A |
| 117 | 1300 | 0.45 | 0.66 | A | A | A |
| 118 | 1350 | 0.45 | 2.00 | A | A | A |
| 119 | 1400 | 0.45 | 4.80 | A | A | A |
| 120 | 1440 | 0.45 | 5.50 | A | B | A |
| 121 | 1460 | 0.45 | 5.90 | B | C | A |
| 122 | 1280 | 0.50 | 0.48 | B | C | A |
| 123 | 1290 | 0.50 | 0.60 | A | B | A |
| 124 | 1300 | 0.50 | 0.66 | A | B | A |
| 125 | 1350 | 0.50 | 2.00 | A | B | A |
| 126 | 1400 | 0.50 | 4.80 | A | B | A |
| 127 | 1440 | 0.50 | 5.50 | A | B | A |
| 128 | 1460 | 0.50 | 5.90 | B | C | A |
| 129 | 1280 | 0.60 | 0.48 | C | C | A |
| 130 | 1290 | 0.60 | 0.60 | B | C | A |
| 131 | 1300 | 0.60 | 0.66 | A | B | A |
| 132 | 1350 | 0.60 | 2.00 | A | B | A |
| 133 | 1400 | 0.60 | 4.80 | A | B | A |
| 134 | 1440 | 0.60 | 5.50 | B | C | A |
| 135 | 1460 | 0.60 | 5.90 | C | C | A |

As is apparent from the results shown in Table 4, in the first suction test, in which 100 pieces of the electronic components 15 were picked up with suction force of 100 kPa, specimens Nos. 101 to 128 where the surface roughness (arithmetic mean roughness Ra) of the inner surface of the suction orifice 3 of the vacuum suction nozzle 1 was not more than 0.5 µm experienced no drop-off of the electronic components 15 and there was no specimen that experienced positional deviation of more than ten pieces suctioned thereon, and were all evaluated as "B" or "A". However, specimens Nos. 129 and 135 where the surface roughness (maximum height Rmax) was 0.48 µm and 5.9 µm, respectively, among the specimens Nos. 129 to 135 where the surface roughness (arithmetic mean roughness Ra) was 0.60 µm, experienced no drop-off of the electronic components 15 but experienced positional deviation of not less than 11 pieces of the electronic components 15, and were evaluated as "C".

In the second suction test, where the suction force was changed to 60 kPa and 100 pieces of the electronic components 15 were picked up, no specimen experienced drop-off of the electronic components 15 or experienced positional deviation of more than ten pieces. However, among specimens where the surface roughness (arithmetic mean roughness Ra) was 0.06 µm and 0.45 µm, only the specimens Nos. 110 to 112 and 117 to 119 where the surface roughness (maximum height Rmax) was from 0.66 µm to 4.80 µm were capable of picking up all the electronic components 15 without positional deviation, and were evaluated as "A".

After cleaning the vacuum suction nozzle 1, the third suction test was conducted with the suction force left to remain at 60 kPa. No positional deviation nor drop-off occurred with all the specimens during suctioning of the electronic components 15. Accordingly, it is considered that positional deviation of the electronic components 15 occurred in the first and second tests, because grit, dust and solder fragments of electrodes that were taken in during vacuum suction of the electronic components 15 deposited on the inner surface of the suction orifice 3 during suctioning of twenty million of the electronic components 15 before the test, thus causing the air flow rate in the suction orifice 3 to be affected by the deposited foreign matters.

Moreover, the least occurrence of positional deviation of the electronic components 15 was observed when the surface roughness (arithmetic mean roughness Ra) was not more than 0.50 µm. When this value becomes larger, grit, dust and solder fragments are caught directly by the protrusions 7 and deposit further thereon. This supposedly decreases the flow rate of air in the suction orifice 3, thus causing frequent incidences of positional deviation.

From the results described above, it can be seen that the surface roughness (arithmetic mean roughness Ra) of the inner surface of the suction orifice 3 is preferably not more than 0.5 µm.

With regard to the relation between the surface roughness (maximum height Rmax) and an occurrence of positional deviation of the electronic components 15, it is concluded as follows from the second suction test in which the suction force was set to 60 kPa. Specimens Nos. 102 to 106, 109 to 113, 116 to 120 and 123 to 127 where the surface roughness (arithmetic mean roughness Ra) was in a range from 0.05 µm to 0.50 µm and the surface roughness (maximum height Rmax) was in a range from 0.60 µm to 5.50 µm were all evaluated as "B" or "A" for positional deviation of the electronic components 15. Specimens Nos. 110 to 112 and 117 to 119 where the surface roughness (arithmetic mean roughness Ra) was 0.06 µm and 0.45 µm and the surface roughness (maximum height Rmax) was in a range from 0.66 µm to 4.80 µm experienced no positional deviation and were evaluated as "A".

Thus it can be seen that there is correlation between the deposition of grit, dust and solder fragments that were taken in during vacuum suction of the electronic components 15 and the surface roughness (maximum height Rmax). When the surface roughness (maximum height Rmax) is small, the protrusions 7 on the inner surface are low and therefore there is small chance of grit, dust and solder fragments to touch the protrusions 7. As a result, the static electricity is not discharged from the grit, dust and solder fragments, and these foreign matters are attracted to deposit onto the inner surface of the suction orifice 3 by the static electricity. Supposedly this decreases the flow rate of air that is taken in and causes positional deviation of the electronic components 15.

When the surface roughness (maximum height Rmax) becomes larger, effective cross sectional area of the flow path in the suction orifice 3 decreases. As a result, grit, dust and solder fragments of electrodes that were taken in during vacuum suction of the electronic components 15 tend to be caught by the protrusions 7 and deposit. This supposedly decreases the suction force further and therefore decreases the flow rate, thus causing positional deviation of the electronic components 15.

The results described above indicate that the surface roughness (maximum height Rmax) of the inner surface of the suction orifice 3 is preferably in a range from 0.60 µm to 5.5 µm, more preferably in a range from 0.66 µm to 4.80 µm.

### (Example 5)

The relation between the surface roughness (maximum height Rmax) and a positional deviation examined in Example 4 was more closely examined in Example 5. During the third suction test of the electronic components 15 conducted in Example 4, air flow rate in the electronic component mounting machine 14 was measured by using a float type flow meter when the vacuum suction nozzle 1 suctioned the electronic components 15 for specimens Nos. 115 to 121. The results are shown in Table 5.

**Table 5**

| Specimen No. | Maximum height Rmax (µm) | Flow rate (L/min) |
|---|---|---|
| 115 | 0.48 | 0.541 |
| 116 | 0.60 | 0.540 |
| 117 | 0.66 | 0.540 |
| 118 | 2.00 | 0.538 |
| 119 | 4.80 | 0.538 |
| 120 | 5.50 | 0.535 |
| 121 | 5.90 | 0.524 |

As is apparent from the results shown in Table 5, the flow rate gradually decreased from 0.541 to 0.535 L/min as the surface roughness (maximum height Rmax) is changed from 0.48 µm to 5.5 µm, and the flow rate sharply decreased to 0.524 L/min when the surface roughness (maximum height Rmax) was 5.90 µm.

While the flow rate of a fluid flowing through a pore is proportional to the cross sectional area of the pore, a flow velocity and a frictional resistance of the inner surface of the pore to the air that is taken in when the suction force is constant, decrease in the flow rate is small when the surface roughness (maximum height Rmax) is in a range from 0.48 µm to 5.5 µm.

From the above discussion, it is considered that a part of air stream flowing through the suction orifice 3 forms eddy currents upon collision with the protrusions 7, and the eddy currents decreases the frictional resistance of the inner surface of the suction orifice 3 to the main stream of air flow, thereby suppressing the flow rate from decreasing.

## Claims

1. A vacuum suction nozzle, comprising:
a base comprising a suction surface on a tip end portion thereof; and
a suction orifice configured to penetrate through the base and communicate to the suction surface, wherein
the tip end portion of the base, including at least the suction surface, is formed from ceramics; and
a plurality of protrusions which have an electrical resistance lower than that of a main component of the ceramics and are formed on an inner surface of the suction orifice.

2. The vacuum suction nozzle according to Claim 1, wherein each of the plurality of protrusions has a semi-spherical shape.

3. The vacuum suction nozzle according to Claim 1 or 2, wherein a height of each of the plurality of protrusions is not more than 30 µm.

4. The vacuum suction nozzle according to any one of Claims 1 to 3, wherein a height of each of the plurality of protrusions is not more than 10% of a diameter of the suction orifice.

5. The vacuum suction nozzle according to any one of Claims 1 to 4, wherein a surface roughness (an arithmetic mean roughness Ra) of the inner surface of the suction orifice is not more than 0.5 µm.

6. The vacuum suction nozzle according to any one of Claims 1 to 5, wherein a surface roughness (a maximum height Rmax) of the inner surface of the suction orifice is not less than 0.6µm nor more than 5.5 µm.

7. The vacuum suction nozzle according to any one of Claims 1 to 6, wherein the plurality of protrusions contain at least one selected from the group consisting of iron oxide, titanium oxide, chromium oxide and cobalt oxide.

## Patentansprüche

1. Vakuumansaugdüse mit:
einer Basis mit einer Ansaugfläche an einem Kopfendabschnitt derselben; und
einer Ansaugöffnung, die dazu ausgebildet ist, die Basis zu durchdringen und mit der Ansaugfläche zu kommunizieren, wobei
der Kopfendabschnitt der Basis, einschließlich wenigstens der Ansaugfläche, aus Keramik ausgebildet ist; und
einer Vielzahl an Vorsprüngen, die einen elektrischen Widerstand aufweisen, der niedriger ist als derjenige einer Hauptkomponente der Keramik und auf einer inneren Fläche der Ansaugöffnung ausgebildet sind.

2. Vakuumansaugdüse nach Anspruch 1, bei der jeder der Vielzahl an Vorsprüngen eine halbkugelförmige Form aufweist.

3. Vakuumansaugdüse nach Anspruch 1 oder 2, bei der eine Höhe von jedem der Vielzahl an Vorsprüngen nicht mehr als 30 µm beträgt.

4. Vakuumansaugdüse nach einem der Ansprüche 1-3, bei der eine Höhe von jedem der Vielzahl an Vorsprüngen nicht mehr als 10 % eines Durchmessers der Ansaugöffnung beträgt.

5. Vakuumansaugdüse nach einem der Ansprüche 1-4, bei der eine Oberflächenrauigkeit (ein arithmetisches Mittel an Rauigkeit Ra) der Innenfläche der Ansaugöffnung nicht mehr als 0.5 µm beträgt.

6. Vakuumansaugdüse nach einem der Ansprüche 1-5, bei der eine Oberflächenrauigkeit (eine maximale Höhe Rmax) der Innenfläche der Ansaugöffnung nicht weniger als 0.6 µm und nicht mehr als 5.5 µm beträgt.

7. Vakuumansaugdüse nach einem der Ansprüche 1-6, bei der die Vielzahl an Vorsprüngen mindestens eines aus der Gruppe, die aus Eisenoxid, Titanoxid, Chromoxid und Kobaltoxid besteht, enthalten.

## Revendications

1. Buse d'aspiration sous vide, comprenant :
une base comprenant une surface d'aspiration sur une partie d'extrémité de bout de celle-ci ; et
un orifice d'aspiration configuré pour pénétrer à travers la base et communiquer avec la surface d'aspiration, dans laquelle
la partie d'extrémité de bout de la base, incluant au moins la surface d'aspiration, est formée de céramique ; et
une pluralité de protubérances qui ont une résistance électrique inférieure à celle d'un composant principal de la céramique et qui sont formées sur une surface intérieure de l'orifice d'aspiration.

2. Buse d'aspiration sous vide selon la revendication 1, dans laquelle chaque protubérance de la pluralité de protubérances a une forme semi-sphérique.

3. Buse d'aspiration sous vide selon la revendication 1 ou 2, dans laquelle une hauteur de chacune de la pluralité de protubérances n'est pas supérieure à 30 µm.

4. Buse d'aspiration sous vide selon l'une quelconque des revendications 1 à 3, dans laquelle une hauteur de chacune de la pluralité de protubérances n'est pas supérieure à 10 % d'un diamètre de l'orifice d'aspiration.

5. Buse d'aspiration sous vide selon l'une quelconque des revendications 1 à 4, dans laquelle une rugosité de surface (une rugosité moyenne arithmétique Ra) de la surface intérieure de l'orifice d'aspiration n'est pas supérieure à 0,5 µm.

6. Buse d'aspiration sous vide selon l'une quelconque des revendications 1 à 5, dans laquelle une rugosité de surface (une hauteur maximale Rmax) de la surface intérieure de l'orifice d'aspiration n'est pas inférieure à 0,6 µm, ni supérieure à 5,5 µm.

7. Buse d'aspiration sous vide selon l'une quelconque des revendications 1 à 6, dans laquelle la pluralité de protubérances contient au moins un élément sélectionné à partir du groupe constitué par l'oxyde de fer, l'oxyde de titane, l'oxyde de chrome et l'oxyde de cobalt.
